# EUROPÄISCHE PATENTANMELDUNG

(11) **EP 4 293 563 A1**
(43) Veröffentlichungstag der Anmeldung: **20.12.2023**
(21) Anmeldenummer: 22179217.9
(22) Anmeldetag: 15.06.2022
(51) Int. Cl.: G06F 30/20

(54) **ANORDNUNG UND VERFAHREN ZUM KALIBRIEREN EINES COMPUTERGESTÜTZTEN SIMULATIONSMODELLS FÜR EIN TECHNISCHES SYSTEM SOWIE COMPUTERPROGRAMMPRODUKT**

(71) Anmelder: Siemens Aktiengesellschaft, 80333 München (DE)
(72) Erfinder: Botero Halblaub, Andrés, 85614 Kirchseeon (DE); Heinrich, Christoph, 86609 Donauwörth (DE); Lorenzi, Juan Manuel, 80796 München (DE); Malik, Vincent, 80636 München (DE); Mauser, Hans, 81739 München (DE)
(74) Vertreter: Siemens Patent Attorneys

(57) **Zusammenfassung**

Die Erfindung betrifft Anordnung, ein computerimplementiertes Verfahren zum Kalibrieren eines computergestützten Simulationsmodells für ein technisches System, sowie ein Computerprogrammprodukt, mit denen Folgendes realisierbar ist:
a) betreiben eines Digitalen Zwillings, wobei dem Digitalen Zwilling mindestens ein Attribut des technischen Systems während aktiver Phasen, wie Produktion, erstmalige Inbetriebnahme, folgender Inbetriebnahmen und/oder bei jedem Betrieb, des technischen Systems, zur Verfügung gestellt wird, wobei der Digitale Zwilling eingerichtet ist, ein technisches Verhalten des technischen Systems zu modellieren,
b) generieren mindestens eines Parameters des computergestützten Simulationsmodells auf Grundlage des Attributs,
c) generieren einer Adaption des computergestützten Simulationsmodells zur Erzeugung eines adaptierten computergestützten Simulationsmodells mit dem Parameter auf Grundlage des Digitalen Zwillings,
d) ausgeben des adaptierten computergestützten Simulationsmodells an einen Simulator.

## Beschreibung

Die Erfindung betrifft eine Anordnung zum Kalibrieren eines computergestützten Simulationsmodells für ein technisches System gemäß dem Gattungsbegriff des Anspruchs 1, ein computergestütztes Verfahren zum Kalibrieren eines computergestützten Simulationsmodells für ein technisches System gemäß dem Gattungsbegriff des Anspruchs 9, sowie ein Computerprogrammprodukt gemäß Anspruch 10.

Es ist bekannt, dass für die Entwicklung von präzisen Simulationsmodelle detaillierte Informationen des simulierten Objekts wie technischen Systemen, beispielsweise Geräten, notwendig sind.

Werden nur Entwicklungsinformationen, wie beispielsweise das genutzte "Computer Aided Design"-, CAD-System, erwartete Materialeigenschaften und/oder Betriebsbedingungen, wie beispielsweise die Belastung im Einsatzfall des mit dem computergestützten Simulationsmodell modellierten technischen Systems oder generell die Randbedingungen eines Einsatzes für die Erstellung eines Simulationsmodells verwendet, führt dies zu den gleichen Ergebnissen für alle physikalischen Objekte.

Das genaue Verhalten einer einzelnen Instanz des technischen Systems, wie beispielsweise eines Gerätes, kann jedoch stark von Faktoren beeinflusst werden, die während der Konstruktion unbekannt sind.

Zu diesen Faktoren können Herstellungsfehler beziehungsweise Ungenauigkeiten, spezifische Konfigurationen oder die Art und Weise, wie das Gerät montiert ist, gehören. Nachteilig ist dabei, dass die Erstellung echtzeitfähiger Modelle für jede einzelne Position beziehungsweise deren Konfiguration eines Geräts sehr viel Zeit beansprucht.

Um die Simulation zu verbessern, werden die Ergebnisse also durch Anpassung einiger Parameter mittels Kalibrierung korrigiert. Die Kalibrierung ist ein zeitaufwändiger Prozess, der zudem auch noch für alle produzierten Objekte notwendig ist.

Es ist daher eine Aufgabe der Erfindung, eine Lösung anzugeben, die die Effizienz und/oder Präzision eines computergestützten Simulationsmodells für den Echtzeiteinsatz gewährleistet.

Die Aufgabe wird durch die Anordnung zum Kalibrieren eines computergestützten Simulationsmodells für ein technisches System gemäß dem Gattungsbegriff des Anspruchs 1, durch dessen Merkmale, durch ein computergestütztes Verfahren zum Kalibrieren eines computergestützten Simulationsmodells für ein technisches System gemäß dem Gattungsbegriff des Anspruchs 9, durch dessen Merkmale, sowie ein Computerprogrammprodukt gemäß Anspruch 10 durch dessen Merkmale gelöst. In den abhängigen Ansprüchen sind vorteilhafte Weiterbildungen der Erfindung dargestellt.

Gemäß einem ersten Aspekt betrifft die Erfindung eine Anordnung zum Kalibrieren eines computergestützten Simulationsmodells für ein technisches System, wobei die Anordnung
a) eine erste Schnittstelle umfasst, die derart eingerichtet ist, dass einem mit einem Digitalen Zwilling funktional verbundenen ihn betreibendes Modul mindestens ein Attribut des technischen Systems während aktiver Phasen, wie Produktion, erstmalige Inbetriebnahme, folgender Inbetriebnahmen und/oder bei jedem Betrieb, des technischen Systems, verfügbar ist, wobei der Digitale Zwilling eingerichtet ist, ein technisches Verhalten des technischen Systems zu modellieren,
b) einen ersten Generator, der derart ausgestaltet ist, dass auf Grundlage des Attributs mindestens ein Parameter des computergestützten Simulationsmodells generiert wird,
c) einen zweiten Generator, der derart ausgestaltet ist, dass mit dem Parameter mithilfe des Moduls auf Grundlage des Digitalen Zwillings eine Adaption des computergestützten Simulationsmodells zur Erzeugung eines adaptierten computergestützten Simulationsmodells erfolgt,
d) eine zweite Schnittstelle, die derart eingerichtet ist, dass das adaptierte computergestützte Simulationsmodell an einen Simulator ausgebbar ist.

Sofern es in der nachfolgenden Beschreibung nicht anders angegeben ist, beziehen sich die Begriffe "durchführen", "berechnen", "rechnergestützt", "rechnen", "feststellen", "generieren", "konfigurieren", "rekonstruieren" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "rechnergestützt" oder "computergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens, der Komponente, der Module, oder anderer Aspekte und/oder Teilaspekte der Erfindung realisiert.

Unter einer "Speichereinheit" oder einem "Speichermodul" und dergleichen kann im Zusammenhang mit der Erfindung beispielsweise ein flüchtiger Speicher in Form von Arbeitsspeicher (engl. Random-Access Memory, RAM) oder ein dauerhafter Speicher wie eine Festplatte oder ein Datenträger sowie eine Kombination aus einer oder mehrerer dieser Elemente zur Bildung einer so genannten Cloud verstanden werden.

Unter einem "Modul" kann im Zusammenhang mit der Erfindung beispielsweise mindestens ein Prozessor und/oder mindestens eine Speichereinheit zum Speichern von Programmbefehlen verstanden werden, welche physisch an einem Ort, beispielsweise einem Teil eine Leiterplatte, oder auch auf mehreren Entitäten eines Netzwerks verteilt funktional zusammenwirkend verbunden sind. Beispielsweise ist der Prozessor speziell dazu eingerichtet, die Programmbefehle derart auszuführen, damit der Prozessor Funktionen ausführt, um das erfindungsgemäße Verfahren oder einen Schritt des erfindungsgemäßen Verfahrens zu implementieren oder realisieren.

Unter einem "computergestützten Simulationsmodell" eines technischen Systems kann insbesondere ein digitaler Zwilling des technischen Systems verstanden werden. Das computergestützte Simulationsmodell ist insbesondere dazu eingerichtet, ein technisches, chemisches und/oder physikalisches Verhalten des technischen Systems oder Produkt des technischen Systems, abzubilden bzw. zu modellieren.

Unter einem "Attribut" des computergestützten Simulationsmodells kann insbesondere eine Einheit wie beispielsweise Physikalische Eigenschaft, Name, Größe, Farbe, Typ, Zustand, Parameter eines Einsatzortes usw., oder ein Merkmal, eine Charakteristik und/oder eine Konfiguration des computergestützten Simulationsmodells oder Produkts verstanden werden.

Unter einem "technischen System" kann insbesondere eine Maschine, wie z.B. eine Werkzeugmaschine oder ein Roboter, ein Gerät, wie z.B. ein Feldgerät, eine industrielle Anlage, wie z.B. eine Produktionsanlage, verstanden werden.

Es ist unter anderem ein Vorteil der vorliegenden Erfindung, dass das computergestützte Simulationsmodell durch den digitalen Zwilling vor einem Austausch und/oder einer Verwendung des technischen Systems zunächst automatisch kalibriert werden kann, in dem durch die Adaption des computergestützten Simulationsmodells auf Grundlage von real erfassten Attributen eine Parametrierung des computergestützten Simulationsmodells realisiert wird.

Gemäß einer weiteren Ausführungsform der Anordnung erfasst mindestens ein Sensor mindestens eine Eigenschaft des technischen Systems und leitet sie als Attribut an die erste Schnittstelle weiter.

Sensoren gibt es in vielfältigen Ausgestaltungen, die es ermöglichen, insbesondere direkt am Ort, an dem das technische System aktiv ist, physikalische Größen zu erfassen, die das technische System und/oder die Umgebung bzw. den Einsatzort charakterisieren und somit für eine Parametrierung zur Kalibrierung hervorragend geeignet sind.

In einer vorteilhaften Ausführungsform der Anordnung kann das mindestens eine Attribut mindestens eine systemrelevante Information, wie beispielsweise
- eine physikalische Eigenschaft des technischen Systems, die durch das computergestützte Simulationsmodell ausgewertet wird,
- einen Zustand des technischen Systems, der durch das computergestützte Simulationsmodell modelliert wird,
- eine Eigenschaft des technischen Systems, der durch das computergestützte Simulationsmodell modelliert wird,
- eine Eigenschaft eines Ergebnisses, insbesondere eines physischen Erzeugnisses, des technischen Systems, der durch das computergestützte Simulationsmodell modelliert wird und/oder
- einen Eingabeparameter des computergestützten Simulationsmodells, beschreiben.

Das computergestützte Simulationsmodell ist somit vorzugsweise durch auf Grundlage von Attributen bestimmter Parameter charakterisiert.

In einer weiteren Ausführungsform der Anordnung kann der erste und/oder zweite Generator, derart, insbesondere als künstliches neuronales Netzwerk, ausgestaltet sein, dass die Adaption auf Grundlage eines Deep Learning Algorithmus, insbesondere nach dem so genannten "Approximate Bayesian Computation"-, ABC-, Algorithmus erfolgt.

Einer der Vorteile der ABC-Methode, die in der Bayes'schen Statistik verwurzelt ist, liegt darin, dass sie zur Schätzung im Zusammenhang mit Modellparametern verwendet werden kann.

Da ABC-Methoden die Ausweitung einer Likelihood-Funktion ermöglichen, erweitern sie auf diese Weise den Bereich der Modelle, für die statistische Schlussfolgerungen in Betracht gezogen werden können.

Es ist ferner ein Vorteil, dass der erste und/oder zweite Generator derart eingerichtet sein kann, die Adaption mittels eines ersten trainierten maschinellen Lernmodells bereitzustellen, wobei das erste maschinelle Lernmodell darauf trainiert ist, anhand eines Attributs eines Kalibrierungsdatensatzes, der einem computergestützten Simulationsmodell eindeutig zugeordnet ist, einen Parameter aus einer Menge von Parametern zu selektieren.

Dies ist vorteilhaft, da anhand eines vorliegenden Attributs ein geeigneter Parameter bestimmt und bereitgestellt werden kann. Somit ist es in diesem Fall nicht nötig, dass ein Kalibrierungsdatensatz vorab bestimmt ist.

In einer weiteren Ausführungsform der Anordnung kann der Simulator derart eingerichtet sein, dass computergestützte Simulationsmodell in einer vorgegebenen Hardware-Simulationsumgebung oder in einer virtuellen Hardware-Simulationsumgebung auszuführen.

Dies ermöglicht insbesondere die Überprüfung einer von im Kalibrierungsdatensatz vorgegebenen Rechendauer oder Ausführleistung des computergestützten Simulationsmodells.

In einer weiteren Ausführungsform kann der mindestens eine Parameter durch eine Ausführung eines weiteren computergestützten Simulationsmodells generiert werden, wobei das weitere computergestützte Simulationsmodell durch das Modul auf Grundlage des Digitalen Zwilling derart eingerichtet ist, dass technische Verhalten des technischen Systems zu repräsentieren.

Gemäß einem zweiten Aspekt betrifft die Erfindung ein computerimplementiertes Verfahren zum Kalibrieren eines computergestützten Simulationsmodells für ein technisches System, umfassend folgende Verfahrensschritte:
a) betreiben eines Digitalen Zwillings, wobei dem Digitalen Zwilling mindestens ein Attribut des technischen Systems während aktiver Phasen, wie Produktion, erstmalige Inbetriebnahme, folgender Inbetriebnahmen und/oder bei jedem Betrieb, des technischen Systems, zur Verfügung gestellt wird, wobei der Digitale Zwilling eingerichtet ist, ein technisches Verhalten des technischen Systems zu modellieren,
b) generieren mindestens eines Parameters des computergestützten Simulationsmodells auf Grundlage des Attributs,
c) generieren einer Adaption des computergestützten Simulationsmodells zur Erzeugung eines adaptierten computergestützten Simulationsmodells mit dem Parameter auf Grundlage des Digitalen Zwillings,
d) ausgeben des adaptierten computergestützten Simulationsmodells an einen Simulator.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, die Schritte eines erfindungsgemäßen Verfahrens auszuführen.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

In einer weiteren Ausführungsform der Anordnung kann der mindestens eine Parameter durch den Kalibrierungsdatensatz bestimmt sein.

Dies ist vorteilhaft, da benötigte Kalibrierungsdaten bereits im Kalibrierungsdatensatz definiert sind. Dadurch kann eine Parametrierung des computergestützten Simulationsmodells auf einfache Weise durchgeführt werden. Beispielsweise kann der mindestens eine Parameter im Kalibrierungsdatensatz gespeichert sein. Es ist auch denkbar, dass der Kalibrierungsdatensatz auf den mindestens einen Parameter verweist, wie z.B. mittels einer Verknüpfung/eines Links zu einem Speicherort des Testdatensatzes.

In einer weiteren Ausführungsform der Anordnung kann der Kalibrierungsdatensatz mit dem mindestens einen Parameter aktualisiert werden.

Hierdurch wird sichergestellt, dass der Kalibrierungsdatensatz mit real sich ergebenden - durch die im Einsatz tatsächlich auftretenden und erfassten Attribute bestimmten - Parameter eine Rückmeldung erhält, die eine entsprechende "Nachregelung", Optimierung und/oder ein maschinelles Lernen ermöglicht.

Ausführungsbeispiele der erfindungsgemäßen Anordnung und des erfindungsgemäßen Verfahrens sind in den Zeichnungen beispielhaft dargestellt und werden anhand der nachfolgenden Beschreibung näher erläutert. Es zeigt die
- Figur 1: eine schematische Darstellung eines Ausführungsbeispiels der erfindungsgemäßen Anordnung zum Kalibrieren eines computergestützten Simulationsmodells für ein technisches System; und die
- Figur 2: ein Ablaufdiagramm als schematische Darstellung eines Ausführungsbeispiels des erfindungsgemäßen computerimplementierten Verfahrens zum Kalibrieren eines computergestützten Simulationsmodells für ein technisches System.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

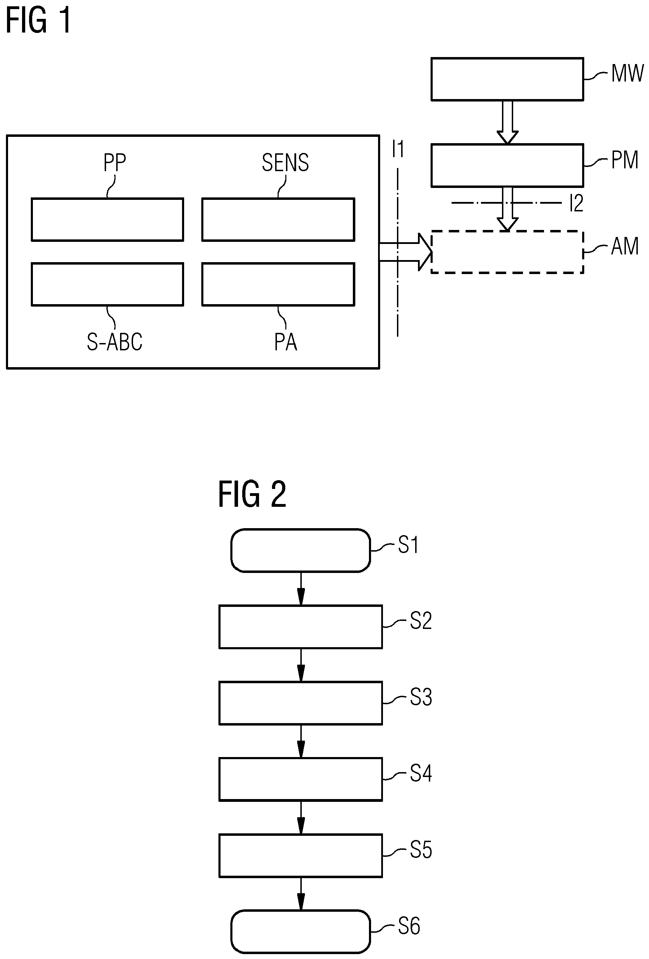

Figur 1 zeigt schematisch ein Ausführungsbeispiel der erfindungsgemäßen Anordnung zum Kalibrieren eines computergestützten Simulationsmodells PM für ein technisches System PP.

Dieses Kalibrieren unterscheidet sich vom aus dem Stand der Technik bekannten Ansatz gemäß der Erfindung dadurch, dass kein herkömmlicher Kalibrierungsprozess durchgeführt werden muss.

Stattdessen wird gemäß der Erfindung ein parametrischer Digitaler Zwilling PM bereitgestellt und dieser mit Messungen kalibriert, die während der Ausführung eines Produktionsprozesses und/oder Inbetriebnahme generiert werden, und zur Erstellung eines adaptierten, also verbesserten, computergestützten Simulationsmodells AM verwendet, welches dann in Echtzeit für präzise Ergebnisse der Simulation gewährleisten kann.

Hierzu lässt sich gemäß einem Ausführungsbeispiel der Erfindung gemäß der Darstellung der Ausführungsform der Anordnung der Erfindung schematisch durch die im Folgenden beschriebenen Elemente charakterisieren.

Das Ausführungsbeispiel der Erfindung nimmt Einfluss auf einen Produktionsprozess PP.

Das technische System gemäß des Ausführungsbeispiels der Erfindung, also das Gerät, das den Produktionsprozess PP durchführt, ist mit mindestens einem Sensor SENS ausgestattet, der die Messungen vornimmt und als Attribute für den Digitalen Zwilling gemäß der Erfindung zur Verfügung stellt.

Hierzu weist die Anordnung gemäß Ausführungsbeispiel ferner ein Modul mit einem serienmäßig implementierten System zum maschinellen Lernen auf, welches auf der Approximative Bayessche Berechnung, auch als so genanntes "Approximate Bayesian Computation" bekannt, beruht und auf vorteilhafte Weise den Raum möglicher Parameter für eine Parametrisierung, mit der gemäß dem erfindungsgemäßen Ausführungsbeispiel das computergestützte Simulationsmodell des Produktionsprozesses PP erfindungsgemäß eingerichtet wird, erweitert.

Damit kann dann ein gemäß dem Ausführungsbeispiel ebenfalls vorhandener Generator Parameter für diesen konkreten Einsatz des Gerätes anhand der in situ mittels Sensorsystem SENS erfassten, den konkreten Einsatz charakterisierenden, Messungen, auf Grundlage eines Parametergenerierungsalgorithmus erzeugen.

Diese Parameter und/oder die durch die Messung verfügbaren Attribute können dann gemäß dem Ausführungsbeispiel der Erfindung zur Adaption des computergestützten Simulationsmodells genutzt werden.

Diese Adaption wird unter anderem gemäß dargestellten Ausführungsbeispiel schematisch durch die auf der rechten Seite der FIGUR 2 dargestellten Elemente repräsentiert.

Diese besteht aus einem Modellierungswerkzeug MW, welches durch den Digitalen Zwilling des technischen Systems gegeben ist beziehungsweise diesen modelliert und der derart gebildet ist, dass er mithilfe eines als Trainingsdatensatz eingesetzten gemäß Erfindung als Kalibrierungsdatensatz bezeichneten Datensatz vor einem Einsatz erzeugten parametrisiertes Simulationsmodell PM repräsentiert.

Mit dem Bereitstellen der Attribute beziehungsweise auf Grundlage der ABC Methode generierten Parameter für das Modelwerkzeug MW aus Einsatz des zuvor lediglich simulierten Gerätes somit eine Adaption des Digitalen Zwillings an reale Gegebenheiten möglich, so dass mit seiner Anpassung auch damit unmittelbar ein adaptiertes parametrisches Simulationsmodell AM gegeben ist.

Das Ausführungsbeispiel und damit die vorliegende Erfindung stellt somit eine Verbesserung des herkömmlichen Verfahrens zur Modellerstellung beziehungsweise dessen Kalibrierung dar, dessen wesentlicher Unterschied darin besteht, dass bei dieser Erfindung unstrukturierte Daten für die Erzeugung und Kalibrierung eines parametrischen digitalen Zwillings verwendet werden. Es muss somit kein zeitaufwändiger Kalibrierungsprozess durchgeführt werden, um die Modellgenauigkeit zu erhöhen.

Die Erfindung ist nicht auf das Ausführungsbeispiel beschränkt, vielmehr sind im Rahmen des fachmännischen Könnens zur Umsetzung der gleichen erfindungsgemäßen Effekte andere Kombinationen einzelner oder aller der erläuterten Elemente denkbar. Ferner sind auch Ergänzungen gemäß der unter den Schutzbereich der Unteransprüche fallenden Weiterbildungen denkbar. Auch sind andere Implementierungen der gezeigten Elemente möglich

Beispielsweise kann es sich bei dem technischen System PP um eine industrielle Produktionsanlage handeln. Das Ausführungsbeispiel kann durch einen weiteren digitalen Zwilling der Prozessanlage ergänzt werden, so können beispielsweise Prozessschritte der Produktion der industriellen Anlage abgebildet werden.

Alternativ kann es sich bei dem technischen System PP auch um eine Maschine, wie z.B. eine Werkzeugmaschine oder ein Motor, handeln. Der digitale Zwilling der Maschine kann beispielsweise ein physikalisches Verhalten der Maschine modellieren.

Die Anordnung oder auch Teile davon können beispielsweise als Teil oder gekoppelt mit einer Plattform (engl. Marketplace) zum Bereitstellen oder zum Austausch digitaler Zwillinge realisiert werden.

Das computergestützte Simulationsmodell wird zusammen mit einem dem computergestützten Simulationsmodell zugeordneten Kalibrierungsdatensatz Kalibrierungsdatensatz bereitgestellt. Der Kalibrierungsdatensatz Kalibrierungsdatensatz kann beispielsweise als Datenstruktur vorliegen, wie z.B. als Textdokument. Vorzugsweise ist der Kalibrierungsdatensatz Kalibrierungsdatensatz dem computergestützten Simulationsmodell bzw. den ihn repräsentierenden Digitalen Zwilling eindeutig zugeordnet, wie z.B. über einen Identifikator des computergestützten Simulationsmodells, der im Kalibrierungsdatensatz Kalibrierungsdatensatz gespeichert ist.

Der Kalibrierungsdatensatz Kalibrierungsdatensatz umfasst mindestens ein Attribut beziehungsweise ein, insbesondere durch maschinelles Lernen aktualisierbare, Parameter des computergestützten Simulationsmodells. Beispielsweise spezifiziert der Kalibrierungsdatensatz Kalibrierungsdatensatz das mindestens eine Attribut beziehungsweise den mindestens einen Parameter des computergestützten Simulationsmodells. Ein Attribut bzw. Parameter beschreibt vorzugsweise eine Ausführungsleistung des computergestützten Simulationsmodells bei Ausführung auf einer vorgegebenen Hardware, eine physikalische Eigenschaft des technischen Systems, die durch das computergestützte Simulationsmodell ausgewertet wird, einen Zustand des technischen Systems, der durch das computergestützte Simulationsmodell modelliert wird, und/oder einen Eingabeparameter des computergestützten Simulationsmodells. Der Kalibrierungsdatensatz Kalibrierungsdatensatz beschreibt folglich in formaler Spezifikationssprache alle Attribute und/oder Merkmale des digitalen Zwillings beziehungsweise des durch ihn repräsentierten computergestützten Simulationsmodells, welches wiederrum ein technisches System beschreibt. Der Kalibrierungsdatensatz Kalibrierungsdatensatz ist vorzugsweise derart ausgestaltet, dass er maschinenlesbar ist.

Der Kalibrierungsdatensatz Kalibrierungsdatensatz kann außerdem mindestens einen Testdatensatz umfassen und/oder auf einen Testdatensatz verweisen. Ein Testdatensatz bezieht sich vorzugsweise auf mindestens ein Attribut des computergestützten Simulationsmodells. Vorzugsweise ist der Testdatensatz dazu geeignet, das Attribut zu kalibrieren.

Beispielsweise kann ein Testdatensatz bzw. Testszenario sich auf einen Zustand des technischen Systems, der durch das computergestützte Simulationsmodell modelliert wird, beziehen. Der Testdatensatz kann eingerichtet sein, einen Ausgabewert dieses Zustands bei Ausführung des computergestützten Simulationsmodells zu ermitteln, wobei der Ausgabewert anschließend gegenüber einem Sollwert dieses Zustands geprüft werden kann.

Der Kalibrierungsdatensatz Kalibrierungsdatensatz kann außerdem mindestens einen Sollwert umfassen, wobei der Sollwert ein vorgegebenes Ergebnis einer Ausführung des computergestützten Simulationsmodells angibt. Insbesondere kann ein jeweiliger Sollwert für ein jeweiliges Attribut definiert sein.

Beispielsweise kann es sich bei einem Attribut auch um eine Ausführungsleistung des computergestützten Simulationsmodells handeln, die mit einem vorbestimmten Sollwert im Kalibrierungsdatensatz Kalibrierungsdatensatz vorgegeben ist.

Es kann ein Testgenerator vorgesehen sein, der ein, insbesondere weiteres, trainiertes maschinelles Lernmodell umfassen kann, das darauf trainiert ist, anhand eines Attributs eines Kalibrierungsdatensatz Kalibrierungsdatensatzes, der einem computergestützten Simulationsmodell eindeutig zugeordnet ist, einen Testdatensatz aus einer Menge von Testdatensätzen zu selektieren. Das maschinelle Lernmodell kann beispielsweise ein künstliches neuronales Netz sein. Das maschinelle Lernmodell ist beispielsweise mittels eines Trainingsdatensatzes trainiert, wobei der Trainingsdatensatz als Trainingseingabedaten eine Vielzahl an Attributen und als Trainingsausgabedaten jeweils den Attributen zugeordnete Testdatensätze umfasst. So kann der Testdatengenerator anhand eines Attributs einen passenden Testdatensatz selektieren und bereitstellen.

Beispielsweise handelt es sich bei dem Testdatensatz für das Attribut, das die Ausführungsleistung des computergestützten Simulationsmodells betrifft, um ein Testszenario, das die Ausführungsleistung des computergestützten Simulationsmodells auf einer vorgegebenen Hardware überprüfen kann.

Das computergestützte Simulationsmodell und der Testdatensatz werden dem Simulator übergeben. Der Simulator ist dazu eingerichtet, das computergestützte Simulationsmodell anhand des Testdatensatzes, vorzugsweise auf einer entsprechend vorgegebenen Hardware, auszuführen und mindestens einen Ausgabewert als Ergebnis der Ausführung des computergestützten Simulationsmodells auszugeben. Der Ausgabewert OUT bezieht sich vorzugsweise auf das zu kalibrierende Attribut beziehungsweise den Parameter.

Der Simulator kann insbesondere dazu eingerichtet sein, das computergestützte Simulationsmodell in einer vorgegebenen Hardware-Simulationsumgebung oder in einer virtuellen Hardware-Simulationsumgebung auszuführen. Dazu kann der Simulator beispielsweise mit einer entsprechenden Hardware oder mit einer Cloudanwendung gekoppelt sein.

Der Ausgabewert wird dem Prüfmodul übergeben. Das Prüfmodul ist dazu eingerichtet, den mindestens einen Ausgabewert OUT anhand mindestens eines vorgegebenen Sollwerts des jeweiligen Attributs zu kalibrieren und ein Kalibrierungsergebnis VAL auszugeben. Der Sollwert eines Attributs ist beispielsweise im Kalibrierungsdatensatz Kalibrierungsdatensatz enthalten.

Alternativ kann der Sollwert SV vom Analysemodul 107 bereitgestellt werden. Beispielsweise kann der Sollwert SV durch eine Ausführung eines weiteren computergestützten Simulationsmodells bestimmt sein, wobei das weitere computergestützte Simulationsmodell auch dazu eingerichtet ist, das technische Verhalten des technischen Systems TS zu modellieren. Vorzugsweise ist das weitere computergestützte Simulationsmodell dem betrachteten Simulationsmodell DT zumindest ähnlich.

Alternativ kann das Analysemodul 107 auch ein zweites trainiertes maschinelles Lernmodell ML2 umfassen, mit dem der mindestens eine Sollwert SV für das zu kalibrierende Attribut ermittelt werden kann. Das zweite maschinelle Lernmodell ML2 ist darauf trainiert, anhand eines Kalibrierungsdatensatz eines computergestützten Simulationsmodells einen Sollwert als Ausgabewert des computergestützten Simulationsmodells auszugeben. Dazu wurde das zweite maschinelle Lernmodell vorzugsweise mit einer Vielzahl von Kalibrierungsdatensätzen von verschiedenen computergestützten Simulationsmodellen als Trainingseingabedaten und jeweils zugeordneten Ausgabewerten der Simulationsmodelle trainiert. In Abhängigkeit eines gegebenen Kalibrierungsdatensatz kann das zweite maschinelle Lernmodell somit einen Ausgabewert bestimmen. Dieser Ausgabewert kann nachfolgend als Sollwert genutzt werden. Das Training des zweiten maschinellen Lernmodells ML2 kann beispielsweise auf dem Analysemodul durchgeführt werden. Alternativ kann das zweite maschinelle Lernmodell trainiert bereitgestellt und derart vom Analysemodul eingelesen werden.

Für das Training des zweiten maschinellen Lernmodells kann insbesondere auch der Ausgabewert des computergestützten Simulationsmodells genutzt werden. Dazu kann der Ausgabewert beispielsweise in einer Speichereinheit zwischengespeichert werden.

Das Kalibrierungsergebnis für ein Attribut kann negativ sein, d.h. der Ausgabewert des Attributs entspricht nicht dem Sollwert des Attributs innerhalb eines vorgegebenen Toleranzbereichs, oder positiv sein, d.h. der Ausgabewert des Attributs entspricht dem Sollwert des Attributs innerhalb des vorgegebenen Toleranzbereichs. Der Toleranzbereich kann beispielsweise im Kalibrierungsdatensatz gespeichert sein.

Die zweite Schnittstelle 105 ist derart eingerichtet, das computergestützte Simulationsmodell bei einem positiven Kalibrierungsergebnisauszugeben. Beispielsweise kann das computergestützte Simulationsmodell lediglich bei einem positiven Kalibrierungsergebnis bereitgestellt, freigegeben oder heruntergeladen werden.

Figur 2 zeigt schematisch ein Ausführungsbeispiel eines erfindungsgemäßen, computerimplementierten Verfahrens zum Kalibrieren eines computergestützten Simulationsmodells eines technischen Systems.

Bei dem Ausführungsbeispiel Verfahrens sei angenommen, dass sich das technische System, in dem es zum Einsatz kommt, um eine Isolationsmaschine handelt, die für die Isolation von Wicklungen eines Motors betrieben wird.

Im ersten Schritt S1 des Ausführungsbeispiels des erfindungsgemäßen Verfahrens wird das computergestützte Simulationsmodell und ein dem computergestützten Simulationsmodell eindeutig zugeordneter Kalibrierungsdatensatz eingelesen. Der Kalibrierungsdatensatz spezifiziert mindestens ein Attribut des computergestützten Simulationsmodells. Das computergestützte Simulationsmodell ist dazu eingerichtet, ein technisches Verhalten des technischen Systems, also der Wicklungsisolationsmaschine, zu modellieren.

Im zweiten Schritt S2 wird die Wickelisolationsmaschine anhand mindestens eines zuvor modellierten Parameters in Abhängigkeit des Kalibrierungsdatensatzes betrieben.

Um nun die Temperatur der Motorwicklung in Echtzeit zu berechnen, ist ein detailliertes Modell des Stators einschließlich der Wicklungsisolation erforderlich. Die Isolation der Wicklung kann für jeden einzelnen Motor unterschiedlich sein, abhängig von den Parametern der Isolationsmaschine.

In einem dritten Schritt S3 wird als ein Ausgabewert mindestens eines an der Wicklungsisolationsmaschine angeordneten Sensors als Attribut, den Widerstand der Statorwicklung wiedergebende physikalische Größen und/oder eine aktuell gegebene Sonneneinstrahlung wiedergebende Größe gemessen und an den Parametergenerierungsalgorithmus weitergebenen.

In einem vierten Schritt S4 werden Parameter aus diesen Attributen erstellt, so dass in einem fünften Schritt S5 der Digitale Zwilling, der die erfindungsgemäß parametrisierte computergestützte Simulation repräsentiert mit den aktuellen Parametern neu modelliert werden kann.

Hierdurch entsteht ein adaptiertes computergestütztes Simulationsmodell, so dass damit die aus den Attributen generierten Parameter in der Simulation der Wickelisolationsmaschine Verwendung finden. Unstrukturierte können also verwendet werden, um im Vorfeld unbekannte Parameter wie den Widerstand der Statorwicklung und die Sonneneinstrahlung dank adaptierten computergestütztem Simulationsmodell berechnen zu können.

Dafür wird in einem sechsten und letzten Schritt S6 das adaptierte computergestützte Simulationsmodell über eine Schnittstelle verfügbar gemacht, so dass diese Adaption abrufbar ist.

Vorzugsweise kann das Verfahren für alle in einem für Wickelisolationsmaschinen gegebenen Kalibrierungsdatensatz angegebenen Attribute durchgeführt werden, wobei jeweils mindestens ein Testdatensatz für ein Attribut bereitgestellt wird.

Digitale Zwillinge bzw. computergestützte Simulationsmodelle von technischen Systemen können für einen gesamten Betriebs- und Produktionszyklus genutzt werden. Dabei kann es nützlich sein, wenn die digitalen Zwillinge zwischen verschiedenen Nutzern ausgetauscht werden können. Allerdings ist ein jeweiliger digitaler Zwilling in der Regel spezifisch für ein technisches System konfiguriert, modelliert ein sehr spezifisches Verhalten und/oder kann nur unter vorgegebenen Bedingungen ausgeführt werden etc. Ein Nutzer, der einen digitalen Zwilling eines technischen Systems nutzen möchte, muss sicherstellen, dass eine funktionale Integrität und/oder Qualität des digitalen Zwillings gewährleistet ist. Beispielsweise könnte eine Verwendung eines digitalen Zwillings, der vorgegebene Spezifikationen nicht einhält, zu Schäden am realen, technischen System führen.

Vorteilhaft ist es daher, wenn die Erfindung derart weitergebildet wird, dass die Modellierung eines einzusetzenden Digitalen Zwillings anhand von Parametern beziehungsweise Attributen vor dem Einsatz erfolgt ist. Dies kann insbesondere durch Rückgriff auf wenige funktionale Schnittstellenstandards, wie z.B. Functional Mockup Interface (FMI), erfolgen, die unter anderem sicherstellen, dass ein digitaler Zwilling auf einfach Weise in ein Zielsystem integriert und ausgeführt werden kann. Ist aber hierauf nicht beschränkt.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt, sondern umfasst alle derartigen vorteilhaften Kombinationen, die unter den Schutzbereich der Ansprüche fallen.

## Patentansprüche

1. Anordnung zum Kalibrieren eines computergestützten Simulationsmodells für ein technisches System, wobei die Anordnung
a) eine erste Schnittstelle umfasst, die derart eingerichtet ist, dass einem mit einem Digitalen Zwilling funktional verbundenen ihn betreibendes Modul mindestens ein Attribut des technischen Systems während aktiver Phasen, wie Produktion, erstmalige Inbetriebnahme, folgender Inbetriebnahmen und/oder bei jedem Betrieb, des technischen Systems, verfügbar ist, wobei der Digitale Zwilling eingerichtet ist, ein technisches Verhalten des technischen Systems zu modellieren,
b) einen ersten Generator, der derart ausgestaltet ist, dass auf Grundlage des Attributs mindestens ein Parameter des computergestützten Simulationsmodells generiert wird,
c) einen zweiten Generator, der derart ausgestaltet ist, dass mit dem Parameter eine mithilfe des Moduls auf Grundlage des Digitalen Zwillings eine Adaption des computergestützten Simulationsmodells zur Erzeugung eines adaptierten computergestützten Simulationsmodells erfolgt,
d) eine zweite Schnittstelle, die derart eingerichtet ist, dass das adaptierte computergestützte Simulationsmodell an einen Simulator ausgebbar ist.

2. Anordnung nach einem der vorhergehenden Ansprüche, wobei der mindesten ein Sensor mindestens eine Eigenschaft des technischen Systems erfasst und als Attribut an die erste Schnittstelle weiterleitet.

3. Anordnung nach einem der vorhergehenden Ansprüche, wobei das mindestens ein Attribut mindestens eine systemrelevante Information, wie beispielsweise
- eine physikalische Eigenschaft des technischen Systems, die durch das computergestützte Simulationsmodell ausgewertet wird,
- einen Zustand des technischen Systems, der durch das computergestützte Simulationsmodell modelliert wird,
- eine Eigenschaft des technischen Systems, der durch das computergestützte Simulationsmodell modelliert wird,
- eine Eigenschaft eines Ergebnisses, insbesondere eines physischen Erzeugnisses, des technischen Systems, der durch das computergestützte Simulationsmodell modelliert wird und/oder
- einen Eingabeparameter des computergestützten Simulationsmodells, beschreibt.

4. Anordnung nach einem der vorhergehenden Ansprüche, **dadurch gekennzeichnet, dass** der erste und/oder zweite Generator, derart, insbesondere als künstliches neuronales Netzwerk, ausgestaltet ist, dass die Adaption auf Grundlage eines Deep Learning Algorithmus, insbesondere nach dem so genannten "Approximate Bayesian Computation"-, ABC-, Algorithmus erfolgt.

5. Anordnung nach einem der vorhergehenden Ansprüche, bei der der Simulator eingerichtet ist, das computergestützte Simulationsmodell in einer vorgegebenen Hardware-Simulationsumgebung oder in einer virtuellen Hardware-Simulationsumgebung auszuführen.

6. Anordnung nach einem der vorhergehenden Ansprüche, bei der der mindestens eine Parameter durch eine Ausführung eines weiteren computergestützten Simulationsmodells generiert wird, wobei das weitere computergestützte Simulationsmodell durch das Modul auf Grundlage des Digitalen Zwilling derart eingerichtet ist, das technische Verhalten des technischen Systems zu repräsentieren.

7. Anordnung nach dem der vorhergehenden Ansprüche, bei der der mindestens eine Parameter durch einen Kalibrierungsdatensatz bestimmt ist.

8. Anordnung nach dem der vorhergehenden Ansprüche, bei der der Kalibrierungsdatensatz mit dem mindestens einen Parameter aktualisiert wird.

9. Computerimplementiertes Verfahren zum Kalibrieren eines computergestützten Simulationsmodells (DT) für ein technisches System (TS), umfassend folgende Verfahrensschritte:
a) betreiben eines Digitalen Zwillings, wobei dem Digitalen Zwilling mindestens ein Attribut des technischen Systems während aktiver Phasen, wie Produktion, erstmalige Inbetriebnahme, folgender Inbetriebnahmen und/oder bei jedem Betrieb, des technischen Systems, zur Verfügung gestellt wird, wobei der Digitale Zwilling eingerichtet ist, ein technisches Verhalten des technischen Systems zu modellieren,
b) generieren mindestens eines Parameters des computergestützten Simulationsmodells auf Grundlage des Attributs,
c) generieren einer Adaption des computergestützten Simulationsmodells zur Erzeugung eines adaptierten computergestützten Simulationsmodells mit dem Parameter auf Grundlage des Digitalen Zwillings,
d) ausgeben des adaptierten computergestützten Simulationsmodells an einen Simulator.

10. Computerprogrammprodukt, das direkt in einen programmierbaren Computer ladbar ist, umfassend Programmcodeteile, die dazu geeignet sind, die Schritte des computerimplementierten Verfahrens Anspruch 9 durchzuführen.
